# EUROPÄISCHE PATENTSCHRIFT

(11) **EP 2 670 226 B1**
(45) Veröffentlichungstag und Bekanntmachung des Hinweises auf die Patenterteilung: **31.12.2014**
(21) Anmeldenummer: 12170205.4
(22) Anmeldetag: 31.05.2012
(51) Int. Cl.: H05K 5/02

(54) **Kommunikationsgerät für ein industrielles Automatisierungssystem**
Communication device for an industrial automation system
Appareil de communication pour un système d'automatisation industriel

(43) Veröffentlichungstag der Anmeldung: 04.12.2013
(73) Patentinhaber: Siemens Aktiengesellschaft, 80333 München (DE)
(72) Erfinder: Kasper, Michael, 90411 Nürnberg (DE); Mehn, Martin, 91074 Herzogenaurach (DE)

(56) Entgegenhaltungen:
- WO-A2-2008/140292
- US-A1- 2002 196 736

## Beschreibung

Netzwerksicherheit gewinnt insbesondere in industriellen Automatisierungssystemen zur Fertigungs- oder Prozeßautomatisierung zunehmend an Bedeutung. Mit Firewalls oder VLANs stehen beispielsweise softwarebasierte Netzwerksicherheitslösungen zur Verfügung. Daneben existieren beispielsweise mit abschließbaren Netzwerkanschlußbuchsen, etwa für RJ45-Ports, und zugehörigen Verriegelungselementen mechanische Netzwerksicherheitslösungen. Nach einem Stecken eines Anschlußsteckers in eine anschließend entsprechend gesicherte Netzwerkanschlußbuchse läßt sich der Anschlußsteckers damit nicht mehr zerstörungsfrei entfernen. Soll eine mechanisch gesicherte Netzwerkanschlußbuchse zu einem späteren Zeitpunkt anderweitig genutzt werden, ist entsprechend herkömmlichen Lösungen ein Entfernen des mechanischen Verriegelungselements mittels eines Spezialwerkzeugs oder Schlüssels erforderlich. Dabei wird das Verriegelungselement üblicherweise entsorgt.

Um Ethernet-Technologie auch in industriellen Automatisierungssystemen nutzen zu können, wird eine DE 100 53 843 C1 eine RJ45-basierte Steckverbindung vorgeschlagen, die eine Spannungsversorgung von angeschlossenen Sensoren oder Aktoren ermöglicht. Hierfür sind zusätzliche Kontakte zur Spannungsversorgungseinspeisung als integraler Bestandteil der Steckverbindung vorgesehen. Buchsenseitig wird eine RJ45-Standardbuchse um einen Isolierkörper erweitert, der zwei Kontaktflächen aufweist. Steckerseitig sind zusätzlich zwei korrespondierende Kontaktelemente angebracht, die mit buchsenseitigen Steckverbindungselementen in Kontakt sind. Auf diese Weise ist eine Nutzung von RJ45-basierten Steckverbindungen in industriellen Automatisierungssystemen möglich, und zwar insbesondere unter Beibehaltung bestehender Crimpverbindungstechniken und Verfahren zur Wellenwiderstandsanpassung.

Aus US 7 950 949 B2 ist ein Netzwerkanschlußstecker bekannt, der zumindest einen Kontakt, ein den Kontakt umfassendes Gehäuse und ein in das Gehäuse eingeführtes Netzwerkkabel umfaßt. Zusätzlich umfaßt das Gehäuse einen Verriegelungsmechanismus, der mit einer korrespondierenden Netzwerkanschlußbuchse zusammenschließbar ist. Darüber hinaus ist ein rohrförmiges Betätigungselement vorgesehen, welches das Netzwerkkabel umgibt, mit dem Gehäuse verbunden ist und den Verriegelungsmechanismus bei Betätigung freigibt. Das Betätigungselement weist einen geringeren Durchmesser als das Gehäuse auf und durchdringt dieses.

In US 2010/0077471 A1 eine Vorrichtung zur sicheren Datenübertragung in einem Prozeßsteuerungssystem beschrieben, bei der Kommunikationsanschlüssen von Netzgeräten Sicherheitsmodule zugeordnet sind, mittels derer Kommunikationsanschlüsse selektiv aktiviert bzw. deaktiviert werden. Hierzu werden beispielsweise mittels einer Überwachungsanwendung ungeschützte, ungenutzte oder ungültigen Kommunikationsverbindungen zugeordnete Netzzugangspunkte ermittelt. Dementsprechend werden Kommunikationsanschlüsse aktiviert bzw. deaktiviert, und ein zugehöriger Netzkonfigurationszustand wird festgeschrieben. Ist ein Netzkonfigurationszustand festgeschrieben, kann mittels der Sicherheitsmodule bei Entfernen eines bisher verbundenen Netzgeräts und Anschluß eines neuen Netzgeräts ein Netzzugang für das neue Netzgerät blockiert werden.

Aus US 8,031,471 B2 ist ein Gehäuse für ein Kommunikationsgerät bekannt, das eine Tür aus einem transparenten Material aufweist, die einerseits eine Sichtkontrolle auf Statusanzeigen und Anschlüsse des vom Gehäuse umfaßten Kommunikationsgeräts ermöglicht und andererseits einen unautorisierten Zugriff auf das Kommunikationsgerät verhindert. Die an einer ersten Seite am Gehäuse angeschlagene Tür ist mittels eines an einer zweiten Seite angeordneten Schlosses verriegelbar. Ansonsten weist das Gehäuse keinerlei funktionale Kopplung zum eingeschlossenen Kommunikationsgerät auf, insbesondere nicht zu Bedien- oder Konfigurationselementen des Kommunikationsgeräts.

Das Dokument WO2008140292, (LEE, Kok Wah) publiziert am 20-11-2008, offenbart zusätzlich ein Kommunikationsgerät mit einer Mehrzahl von Sende und Empfangseinheiten.

Der vorliegenden Erfindung liegt die Aufgabe zugrunde, ein Kommunikationsgerät für ein industrielles Automatisierungssystem zu schaffen, das eine einfach handhabbare und wirksame Sicherung von Kommunikationsanschlüssen gegenüber einem unbefugten Zugriff ermöglicht.

Diese Aufgabe wird erfindungsgemäß durch ein Kommunikationsgerät mit den in Anspruch 1 angegebenen Merkmalen gelöst. Vorteilhafte Weiterbildungen der vorliegenden Erfindung sind in den abhängigen Patentansprüchen angegeben.

Das erfindungsgemäße Kommunikationsgerät für ein industrielles Automatisierungssystem umfaßt eine Mehrzahl von Sende- und Empfangseinheiten, die jeweils einen Anschluß für eine Netzverbindung des industriellen Kommunikationsnetzes aufweisen und über ein Koppelelement schaltbar miteinander verbindbar sind. Beispielsweise kann das Kommunikationsgerät eine Bridge oder ein Switch eines industriellen Kommunikationssystems sein. Zusätzlich ist zumindest eine Überwachungseinrichtung vorgesehen, die zumindest einem Anschluß zugeordnet sowie zur Erfassung einer Belegung des jeweiligen Anschlusses ausgestaltet und eingerichtet ist. Darüber hinaus umfaßt das erfindungsgemäße Kommunikationsgerät eine Mehrzahl von durch einen Benutzer betätigbaren Schaltvorrichtungen, die jeweils einem Anschluß zugeordnet sowie zur Aktivierung und Deaktivierung des jeweiligen Anschlusses ausgestaltet und eingerichtet sind. Mit den Schaltvorrichtungen ist eine durch einen Zugriffsschutz gesicherte Freigabevorrichtung verbundenen, durch welche die Schaltvorrichtungen für eine Betätigung aktivierbar sind. Die durch einen Zugriffsschutz gesicherte Freigabevorrichtung kann beispielsweise ein Schlüsselschalter sein. Dabei kann die Schaltvorrichtungen in einer ersten Schlüsselstellung gegen eine Betätigung gesperrt sein, während die Schaltvorrichtungen in einer zweiten Schlüsselstellung betätigbar sein können. Des weiteren weist das erfindungsgemäße Kommunikationsgerät eine Mehrzahl von Statusanzeigevorrichtungen auf, die jeweils einem Anschluß zugeordnet sowie für eine Signalisierung eines Belegungs- bzw. Aktivierungszustandes des jeweiligen Anschlusses ausgestaltet und eingerichtet sind. Insgesamt ermöglicht das erfindungsgemäße Kommunikationsgerät eine einfache Nutzung von sicherheitskritischen Funktionen, wie Portsperren setzen, ändern oder aufheben, auf Feldebene durch autorisiertes Personal mittels der durch einen Zugriffsschutz gesicherten Freigabevorrichtung, ohne daß hierzu aufwendige bzw. nicht unbedingt auf jedem Serviceendgerät installierte Projektierungs- oder Netzmanagementwerkzeuge erforderlich sind. In entsprechender Weise ermöglichen die Statusanzeigevorrichtungen eine einfach durch Bedienpersonal erfaßbare Signalisierung einer netzwerk- oder geräteseitigen Zustandsdiagnose.

Entsprechend einer bevorzugten Weiterbildung der vorliegenden Erfindung sind die Schaltvorrichtungen neben dem jeweils zugeordneten Anschluß angeordnete Taster. Dies ermöglicht eine besonders einfache und sichere Aktivierung bzw. Deaktivierung von Anschlüssen. Darüber hinaus sind die Statusanzeigevorrichtungen vorzugsweise neben dem jeweils zugeordneten Anschluß angeordnete lichtemittierende Dioden. Dies ermöglicht eine schnell und korrekt erfaßbare Darstellung von Statusinformationen. Eine besonders zuverlässige Überwachung eines link down bzw. abgezogenen Anschlußkabels ist entsprechend einer weiteren Ausgestaltung des erfindungsgemäßen Kommunikationsgeräts möglich, wenn die Statusanzeigevorrichtungen jeweils für eine Signalisierung eines geänderten Belegungszustandes eines zuvor belegten und aktivierten zugeordneten Anschlusses ausgestaltet und eingerichtet sind.

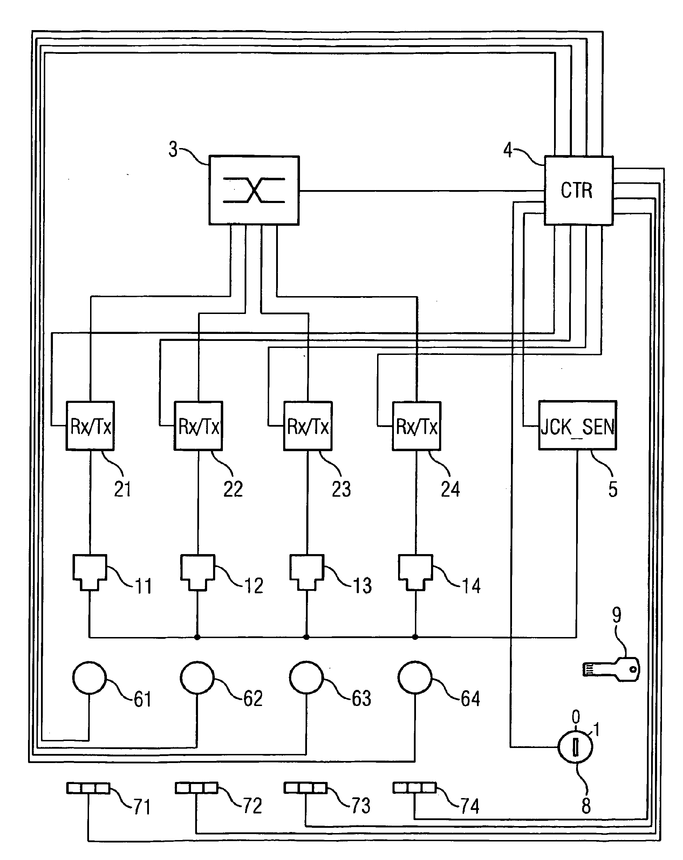

Die vorliegende Erfindung wird nachfolgend an einem Ausführungsbeispiel anhand der Zeichnung näher erläutert. Es zeigt die
- Figur: eine schematische Darstellung eines gesicherten Kommunikationsgeräts für ein industrielles Automatisierungssystem.

Das in der Figur dargestellte Kommunikationsgerät umfaßt eine Mehrzahl von Sende- und Empfangseinheiten 21-24, denen jeweils eine Anschlußbuchse 11-14 für ein Patchkabel zugeordnet ist, mit dem Automatisierungsgeräte wie Steuerungen, dezentrale Steuerungsperipherie, Sensoren, Aktoren oder gesteuerte Maschinen mit dem Kommunikationsgerät verbunden werden können. Im vorliegenden Ausführungsbeispiel handelt es sich bei dem Kommunikationsgerät um einen Switch. Nachfolgende Ausführungen gelten jedoch gleichermaßen auch für andere Kommunikationsgeräte wie Bridges oder Router. Die Sende- und Empfangseinheiten 21-24 sind über ein Koppelelement 3, das beispielsweise durch einen Backplane Switch realisiert ist, schaltbar miteinander verbindbar und weisen dementsprechend Verbindungen zum Koppelelement 3 auf.

Die Anschlußbuchsen 11-14 sind mit einer Überwachungseinrichtung 5 verbunden, die zur Erfassung eines Belegungszustandes der Anschlußbuchsen 11-14 ausgestaltet und eingerichtet ist und dementsprechend Meldungen über einen Belegungszustand an eine dem Koppelelement 3 zugeordnete Steuerungseinheit 4 übermittelt.

Den Anschlußbuchsen 11-14 bzw. den Sende- und Empfangseinheiten 21-24 ist jeweils eine durch einen Benutzer betätigbare Schaltvorrichtung 61-64 zugeordnet, die zur Sperrung und Entsperrung eines zugeordneten Ports ausgestaltet und eingerichtet sowie mit der Steuerungseinheit 4 verbunden ist. Im vorliegenden Ausführungsbeispiel sind die Schaltvorrichtungen 61-64 neben einer jeweils zugeordneten Anschlußbuchse 11-14 angeordnete Taster.

Über die Steuerungseinheit 4 ist mit den Schaltvorrichtungen 61-64 eine durch einen Zugriffsschutz gesicherte Freigabevorrichtung 8 verbunden, durch welche die Schaltvorrichtungen 61-64 für eine Betätigung zur Sperrung bzw. Entsperrung von Ports aktivierbar sind. Im vorliegenden Ausführungsbeispiel ist die durch einen Zugriffsschutz gesicherte Freigabevorrichtung 8 ein zumindest einen Anschlußkontakt umfassender Schlüsselschalter. Der Schlüsselschalter weist einen Schließzylinder auf, in den ein Freigabeschlüssel 9 steckbar ist, so daß die Schaltvorrichtungen 61-64 in einer ersten Schlüsselstellung (0) gegen eine Betätigung gesperrt sind. Dagegen sind die Schaltvorrichtungen 61-64 in einer zweiten Schlüsselstellung (1) betätigbar. Im vorliegenden Ausführungsbeispiel läßt sich der Freigabeschlüssel 9 nur in der ersten Schlüsselstellung aus dem Schließzylinder ziehen, so daß für die zweite Schlüsselstellung stets ein gesteckter Freigabeschlüssel erforderlich ist.

Darüber hinaus umfaßt das in der Figur dargestellte Kommunikationsgerät eine Mehrzahl von Statusanzeigevorrichtungen 71-74, die jeweils einem Port zugeordnet sowie für eine Signalisierung eines Belegungs- bzw. Aktivierungszustandes des jeweiligen Ports ausgestaltet und eingerichtet sind und durch die Steuerungseinheit 4 angesteuert werden. Im vorliegenden Ausführungsbeispiel sind die Statusanzeigevorrichtungen 71-74 neben einer jeweils zugeordneten Anschlußbuchse 71-74 angeordnete lichtemittierende Dioden. Insbesondere signalisieren die Statusanzeigevorrichtungen jeweils einen geänderten Belegungszustand einer zuvor belegten Anschlußbuchse eines aktivierten Ports. Somit ist ein link down bzw. ein abgezogenes Patchkabel einfach kontrollierbar.

Insgesamt ermöglicht die vorliegende Erfindung eine einfache und zuverlässige Sperrung von freien Ports an Netzwerkkomponenten gegen unbefugte Nutzung, indem beispielsweise ein an einer zu schützenden Netzwerkkomponente integrierter Schlüsselschalter in Verbindung mit einem SET-Taster zur selektiven Deaktivierung eines Ports genutzt wird. Durch Betätigung des Schlüsselschalters wird eine Sonderfunktion des SET-Tasters zur Portdeaktivierung freigeschaltet, die in Ausgangsposition des Schlüsselschalters deaktiviert ist. Belegte Ports werden mittels Meldekontakten überwacht, wodurch bei Abziehen eines Steckers eine Meldung generiert wird.

Die Anwendung der vorliegenden Erfindung ist nicht auf das beschriebene Ausführungsbeispiel beschränkt.

## Patentansprüche

1. Kommunikationsgerät für ein industrielles Automatisierungssystem mit
- einer Mehrzahl von Sende- und Empfangseinheiten (21-24), die jeweils einen Anschluß für eine Netzverbindung des industriellen Kommunikationsnetzes aufweisen und über ein Koppelelement schaltbar miteinander verbindbar sind,
- zumindest einer Überwachungseinrichtung 5, die zumindest einem Anschluß zugeordnet sowie zur Erfassung einer Belegung des jeweiligen Anschlusses ausgestaltet und eingerichtet ist,
- einer Mehrzahl von durch einen Benutzer betätigbaren Schaltvorrichtungen (61-64), die jeweils einem Anschluß zugeordnet sowie zur Aktivierung und Deaktivierung des jeweiligen Anschlusses ausgestaltet und eingerichtet sind,
- einer mit den Schaltvorrichtungen verbundenen, durch einen Zugriffsschutz gesicherten Freigabevorrichtung 8, durch welche die Schaltvorrichtungen für eine Betätigung aktivierbar sind,
- einer Mehrzahl von Statusanzeigevorrichtungen (71-74), die jeweils einem Anschluß zugeordnet sowie für eine Signalisierung eines Belegungs- und/oder Aktivierungszustandes des jeweiligen Anschlusses ausgestaltet und eingerichtet sind.

2. Kommunikationsvorrichtung nach Anspruch 1,
bei der die durch einen Zugriffsschutz gesicherte Freigabevorrichtung ein Schlüsselschalter ist.

3. Kommunikationsvorrichtung nach Anspruch 2,
bei der die Schaltvorrichtungen in einer ersten Schlüsselstellung gegen eine Betätigung gesperrt sind, und bei der die Schaltvorrichtungen in einer zweiten Schlüsselstellung betätigbar sind.

4. Kommunikationsvorrichtung nach einem der Ansprüche 1 bis 3,
bei der die Schaltvorrichtungen neben dem jeweils zugeordneten Anschluß angeordnete Taster sind.

5. Kommunikationsvorrichtung nach einem der Ansprüche 1 bis 4,
bei der die Statusanzeigevorrichtungen neben dem jeweils zugeordneten Anschluß angeordnete lichtemittierende Dioden sind.

6. Kommunikationsvorrichtung nach einem der Ansprüche 1 bis 5,
bei der die Statusanzeigevorrichtungen jeweils für eine Signalisierung eines geänderten Belegungszustandes eines zuvor belegten und aktivierten zugeordneten Anschlusses ausgestaltet und eingerichtet sind.

## Claims

1. Communication device for an industrial automation system, having
- a plurality of transmitting and receiving units (21-24) which each have a terminal for a network connection of the industrial communication network and can be connected to one another in a switchable manner via a coupling element,
- at least one monitoring device (5) which is assigned to at least one terminal and is configured and set up to detect allocation of the respective terminal,
- a plurality of switching apparatuses (61-64) which can be actuated by a user, are each assigned to a terminal and are configured and set up to activate and deactivate the respective terminal,
- a release apparatus (8) which is connected to the switching apparatuses, is protected by access protection and can be used to activate the switching apparatuses for actuation,
- a plurality of status display apparatuses (71-74) which are each assigned to a terminal and are configured and set up to signal an allocation and/or activation state of the respective terminal.

2. Communication apparatus according to Claim 1,
in which the release apparatus protected by access protection is a key switch.

3. Communication apparatus according to Claim 2,
in which the switching apparatuses are locked against actuation in a first key position, and in which the switching apparatuses can be actuated in a second key position.

4. Communication apparatus according to one of Claims 1 to 3,
in which the switching apparatuses are buttons arranged beside the respectively assigned terminal.

5. Communication apparatus according to one of Claims 1 to 4,
in which the status display apparatuses are light-emitting diodes arranged beside the respectively assigned terminal.

6. Communication apparatus according to one of Claims 1 to 5,
in which the status display apparatuses are each configured and set up to signal a changed allocation state of a previously allocated and activated assigned terminal.

## Revendications

1. Appareil de communication pour un système d'automatisation industriel, comprenant
- une multiplicité d'unités ( 21 à 24 ) d'émission et de réception, qui ont respectivement un accès pour une liaison du réseau de communication industriel et qui peuvent être reliées entre elles de manière commutable par un élément de couplage,
- au moins un dispositif ( 5 ) de contrôle, qui est associé à au moins un accès et qui est conformé et agencé pour la détection d'une occupation de l'accès respectif,
- une multiplicité de dispositifs ( 61 à 64 ) de commutation, qui peuvent être actionnés par un utilisateur et qui sont associés respectivement à un accès, ainsi que conformés et agencés pour l'activation et la désactivation de l'accès respectif,
- un dispositif ( 8 ) de libération, qui est relié aux dispositifs de commutation, qui est sécurisé par une protection d'accès et par lequel les dispositifs de commutation peuvent être activés pour un actionnement,
- une multiplicité de dispositifs ( 71 à 74 ) d'indication d'état, qui sont associés respectivement à un accès et qui sont conformés et agencés pour une signalisation d'un état d'occupation et/ou d'activation de l'accès respectif.

2. Dispositif de communication suivant la revendication 1,
dans lequel le dispositif de libération sécurisé par une protection d'accès est un commutateur à clé.

3. Dispositif de communication suivant la revendication 2,
dans lequel les dispositifs de commutation sont empêchés d'être actionnés dans une première position de la clé et dans lequel les dispositifs de commutation peuvent être actionnés dans une deuxième position de la clé.

4. Dispositif de communication suivant l'une des revendications 1 à 3,
dans lequel les dispositifs de commutation sont des touches disposées à côté de l'accès associé respectivement.

5. Dispositif de communication suivant l'une des revendications 1 à 4,
dans lequel les dispositifs d'indication d'état sont des diodes électroluminescentes disposées respectivement à côté de l'accès associé.

6. Dispositif de communication suivant l'une des revendications 1 à 5,
dans lequel les dispositifs d'indication d'état sont conformés et agencés pour une signalisation d'une modification de l'état d'occupation d'un accès associé précédemment occupé et activé.
